# EUROPÄISCHE PATENTANMELDUNG

(11) **EP 2 811 578 A1**
(43) Veröffentlichungstag der Anmeldung: **10.12.2014**
(21) Anmeldenummer: 14166128.0
(22) Anmeldetag: 28.04.2014
(51) Int. Cl.: H01R 12/58, B60Q 9/00, H05K 3/32, H05K 3/30, H05K 1/14

(54) **Fahrerassistenzeinrichtung für ein Kraftfahrzeug sowie Verfahren zum Herstellen einer solchen**

(30) Priorität: 06.06.2013 DE 102013009556
(71) Anmelder: Valeo Schalter und Sensoren GmbH, 74321 Bietigheim-Bissingen (DE)
(72) Erfinder: Felber, Franz, 86681 Fuenfstetten (DE); Brunner, Erhard, 86720 Nordlingen-Lopfingen (DE)

(57) **Zusammenfassung**

Es wird eine Fahrerassistenzeinrichtung für ein Kraftfahrzeug vorgeschlagen, welche über eine Tongebereinheit (6) zum Ausgeben von akustischen Signalen und eine Leiterplatte (7) verfügt, die mit der Tongebereinheit (6) elektrisch gekoppelt ist, wobei erfindungsgemäß die elektrische Kopplung über zumindest ein stiftförmiges elektrisches Kontaktelement (8) erfolgt, über welches zudem die Tongebereinheit (6) an der Leiterplatte (7) mechanisch fixiert ist.

## Beschreibung

Die Erfindung betrifft eine Fahrerassistenzeinrichtung für ein Kraftfahrzeug, mit einer Tongebereinheit zum Ausgeben von akustischen Signalen, und mit einer Leiterplatte, an welche die Tongebereinheit elektrisch angekoppelt ist. Die Erfindung bezieht sich auch auf ein Verfahren zum Herstellen einer derartigen Fahrerassistenzeinrichtung.

Bei einem derartigen Fahrerassistenzsystem, insbesondere einer Einparkhilfe, werden für den Fahrzeugführer hörbar akustische Signale ausgegeben, welche die vom Assistenzsystem erfasste Größe, beispielsweise den Abstand zu einem Hindernis, repräsentieren. Ein solches Fahrerassistenzsystem umfasst typischerweise Sensoren, ein Steuergerät und eine Tongebereinheit. Die Sensoren sind beispielsweise in den vorderen und hinteren Stossstangen untergebrachte Ultraschallsensoren und elektrisch mit dem Steuergerät verbunden. Von den Sensoren erfasste Signale werden zur Signalauswertung an das Steuergerät übermittelt, welches die Tongebereinheit und damit die Informationsübermittlung an den Fahrzeughalter kontrolliert.

In der Offenlegungsschrift DE 10 2009 019 380 A1 ist ein solches System vorgeschlagen. Es handelt sich um ein Umfelderkennungssystem an einem Fahrzeug, z.B. ein ultraschallbasiertes Parkassistenzsystem. In der zitierten Schrift sind Tongebereinheit und das im wesentlichen aus einer Leiterplatte bestehende Steuergerät in einem Gehäuse untergebracht, was gegenüber einem System mit in separaten Gehäusen untergebrachten Einheiten bei der Montage Platz und Zeit spart.

Bei der bekannten Anordnung wird die Tongebereinheit über die Leiterplatte des Steuergerätes gelegt und elektrisch kontaktiert. Dabei ist zum Einen die elektrische Kontaktierung relativ aufwändig, zum Anderen die für den Klang relevante Position der Tongebereinheit bis zum Anbringen des gemeinsamen Gehäuses nicht endgültig fixiert, sodass hier besonders sorgsam gearbeitet werden muss.

Es ist Aufgabe der Erfindung, eine Fahrerassistenzeinrichtung der eingangs genannten Gattung so zu gestalten, dass der Fertigungsprozess im Vergleich zum Stand der Technik vereinfacht werden kann.

Diese Aufgabe wird erfindungsgemäß durch eine Fahrerassistenzeinrichtung, durch ein Kraftfahrzeug und durch ein Verfahren mit den Merkmalen gemäß den jeweiligen unabhängigen Patentansprüchen gelöst. Vorteilhafte Ausführungen der Erfindung sind Gegenstand der abhängigen Ansprüche, der Beschreibung und der Figuren.

Bei einer erfindungsgemäßen Fahrerassistenzeinrichtung erfolgt eine elektrische Kopplung zwischen einer Tongebereinheit und einer Leiterplatte der Fahrerassistenzeinrichtung über zumindest ein stiftförmiges Kontaktelement, welches aufgrund seiner mechanischen Stabilität und Steifigkeit auch die Tongebereinheit auf bzw. an der Leiterplatte mechanisch hält. Der besondere Vorteil liegt hier im vereinfachten Fertigungsprozess, der es erlaubt, in einem einfachen Schritt gleichzeitig sowohl das elektrische Kontaktieren als auch das mechanische Fixieren der jeweiligen Elemente - also Tongebereinheit, Leiterplatte und Kontaktelement - durchzuführen. Auch ist kein zusätzliches Bauelement als Halterung der Tongebereinheit vonnöten, und die Einrichtung kommt aufgrund der im Vergleich zum einfachen Auflegen der Tongebereinheit erhöhten Genauigkeit mit weniger Bauraum aus. Ein weiterer Vorteil ist, dass die erfindungsgemäße Ausführung im Fertigungsprozess das Anbringen der Tongebereinheit an die bereits bestückte Leiterplatte erlaubt. Auch wird durch die Verwendung der stiftartigen Kontaktelemente der Ton der Tongebereinheit verbessert.

Eine vorteilhafte Ausführungsform der Erfindung sieht vor, an einem der Leiterplatte zugewandten ersten Ende des Kontaktelements einen ersten Einpressbereich auszuformen, der plastisch und/oder elastisch verformbar ist. Dieser Bereich ist in eine korrespondierende Aussparung der Leiterplatte eingepresst und stellt eine kraft- und formschlüssige Verbindung zwischen der Leiterplatte und dem Kontaktelement her. Besonders eignen sich hier sogenannte "Pressfit-Verbinder", die in dem Fertigungsprozess in die Leiterplatte eingepresst oder "hineingeschossen" werden können. Eine mögliche Form der Einpressbereiche der Kontaktelemente weist zwei sich in einem Abstand zueinander erstreckende bauchartige Schenkel auf, welche durch das Einpressen in die zugeordnete Aussparung der Leiterplatte gegeneinander gepresst werden. Gegenüberliegende äußere Flächen des Einpressbereiches, insbesondere der Schenkel, sind zweckmäßigerweise gewölbt gekrümmt. Der Einpressbereich kann zum Herstellen von sowohl einer unlösbaren als auch einer lösbaren Verbindung ausgebildet sein.

In einer weiteren Ausführungsform kann - zusätzlich oder alternativ zum oben genannten ersten Einpressbereich - an einem der Tongebereinheit zugewandten zweiten Ende des Kontaktelements ein zweiter Einpressbereich ausgeformt sein, der ebenfalls plastisch und/oder elastisch verformbar ist. Dieser ist dann entsprechend in eine korrespondierende Aussparung der Tongebereinheit eingepresst und stellt eine kraft- und formschlüssige Verbindung zwischen der Tongebereinheit und dem Kontaktelement her. Die Verwendung oben genannter Pressfit-Verbinder ermöglicht hier eine Vereinfachung des Fertigungsprozesses. Bei dieser Erweiterung werden zunächst die Kontaktelemente auf die Leiterplatte und dann die Tongebereinheit auf die Kontaktelemente gepresst. Bei geeigneter Wahl der Länge der Kontaktelemente kann der Pressvorgang auch erfolgen, wenn die Leiterplatte bereits bestückt ist, also insbesondere am Ende eines bereits bestehenden Fertigungsprozesses. Diese Ausführungsform ermöglicht also eine Erweiterung des Fertigungsprozesses ohne umständliches Abändern einer bereits bestehenden Fertigungsreihenfolge.

In einer weiteren möglichen Ausführungsform der Erfindung weist die Fahrerassistenzeinrichtung eine an der Leiterplatte angeordnete Steuereinheit zum Ansteuern der Tongebereinheit auf, die über das zumindest eine Kontaktelement mit der Tongebereinheit elektrisch gekoppelt ist. Vorteilhaft ist hier die direkte elektrische Kopplung der beiden Einheiten, die beispielsweise eine elektrische Kopplung über eine zusätzliche Steckverbindung überflüssig macht.

Besonders vorteilhaft ist eine Ausführungsform mit mindestens zwei, insbesondere vier, Kontaktelementen. Mindestens zwei Kontaktelemente ermöglichen eine ausschließlich über die Kontaktelemente erfolgende elektrische Kopplung der Tongebereinheit an die Leiterplatte. Bei entsprechendem Layout der Leiterplatte können so mittels ausreichend vielen Kontaktelementen weitere, auch mehrpolige elektrische Kopplungen zwischen Steuer- und Tongebereinheit ersetzt werden. Vier Kontaktelemente ermöglichen eine besonders stabile mechanische Verbindung der handelsüblichen viereckigen Tongebereinheiten, insbesondere wenn die Kontaktelemente in den jeweiligen Eckbereichen der Tongebereinheit angebracht sind.

Eine mögliche Ausführungsform der Erfindung beinhaltet mindestens ein Kontaktelement, welches einen Abstand zwischen der Tongebereinheit und der Leiterplatte überbrückt. Die Beabstandung bietet den Vorteil, dass eine Kühlung der Bauteile gefördert wird und der Klang der Tongebereinheit durch die Wahl des Abstands beeinflusst wird. Über die Form, insbesondere die Länge, des Kontaktelements kann ein bestimmter, für die im jeweiligen Einzelfall maßgeblichen Randbedingungen optimaler Abstand eingehalten werden.

Der im vorangegangenen Absatz erwähnte Abstand zwischen der Tongebereinheit und der Leiterplatte kann insbesondere einen Zwischenraum ausbilden, in dem zumindest eine der auf der Leiterplatte angebrachten elektronischen Komponenten angeordnet ist. Diese elektronische Komponente liegt dann quasi "unter" der Tongebereinheit. Durch diese "doppelstöckige" Anbringung wird Bauplatz gespart. Auch können bereits vorhandene, gleiche Leiterplatten, insbesondere eine Layoutänderung vorausgesetzt, bei gleichbleibender sonstiger Belegung der elektronischen Komponenten so ohne eine Vergrößerung ihrer Abmessungen in ihrem Funktionsumfang erweitert werden. Das ist insofern bedeutsam, als das gerade in modernen Kraftfahrzeugen der Platz von Bauteilen, wie z.B. denen eines Fahrerassistenzsystems, sehr eng bemessen ist und nur mit großem Aufwand geändert werden kann.

Ein weiterer Vorteil der "doppelstöckigen" Ausführungsform ergibt sich aus der Tatsache, dass eine Tongebereinheit im Normalfall einen hohen Metallgehalt z.B. in Form einer Beschichtung aufweist. Dadurch werden elektronische Komponenten, die -wie im letzten Absatz beschrieben - zwischen Leiterplatte und Tongebereinheit angeordnet sind, gegen elektromagnetische Strahlung abgeschirmt. Eine aufwändige zusätzliche Abschirmung kann so eingespart werden.

Die Tongebereinheit kann auch einen Tongeber zur Ausgabe der akustischen Signale sowie zusätzlich eine weitere Leiterplatte aufweisen, welche über das zumindest eine Kontaktelement mit der einen, ersten Leiterplatte verbunden ist. Dies erleichtert unter Umständen das Verbinden der verschiedenen Elemente.

Die Leiterplatte und die Tongebereinheit können in einem gemeinsamen Gehäuse angeordnet sein. Dies schützt vor Verschmutzung und vereinfacht die Montage im Kraftfahrzeug.

In einer möglichen Ausführungsform der Erfindung ist die Fahrerassistenzeinrichtung ein Parkhilfesystem, welches zumindest einen Abstandssensor, insbesondere einen Ultraschallsensor, zum Erfassen eines Abstands zu einem Hindernis aufweist, wobei mittels der Tongebereinheit akustische Signale ausgebbar sind, die den erfassten Abstand charakterisieren. Hierbei wertet ein Steuergerät die Signale der Abstandssensoren aus. Das Steuergerät umfasst die Leiterplatte, auf die ein "kleiner Tongeber" als die Tongebereinheit mit einem oder mehreren Kontaktstiften, insbesondere sogenannten "Pressfit-Verbindern", direkt auf der Leiterplatte angebracht ist. Die Länge der "Pressfitbeine" ist so gewählt, dass eine Montage auf der bestückten Platine bzw. Leiterplatte erfolgen kann.

Die Erfindung betrifft auch ein Verfahren zum Herstellen einer Fahrerassistenzeinrichtung für ein Kraftfahrzeug, bei welchem eine Tongebereinheit, welche zum Ausgeben von akustischen Signalen ausgebildet ist, sowie eine Leiterplatte, an welche die Tongebereinheit elektrisch angekoppelt wird, bereitgestellt werden. Weiterhin wird im Verlauf des Verfahrens zumindest ein stiftförmiges elektrisches Kontaktelement bereitgestellt, über welches die Tongebereinheit an der Leiterplatte befestigt und an die Leiterplatte elektrisch angekoppelt wird.

Die mit Bezug auf die erfindungsgemäße Fahrerassistenzeinrichtung vorgestellten bevorzugten Ausführungsformen und deren Vorteile geltend entsprechend für das erfindungsgemäße Verfahren.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar.

Ein Ausführungsbeispiel der Erfindung wird nachfolgend anhand der Figuren erläutert.

Dabei zeigen:
- Fig. 1: in schematischer Darstellung eine Außenansicht eines Steuergeräts einer Fahrerassistenzeinrichtung gemäß einer Ausführungsform der Erfindung, wobei Leiterplatte und Tongebereinheit in einem Gehäuse untergebracht sind und das Gehäuse eine Öffnung für die Signale der Tongebereinheit hat;
- Fig. 2: in schematischer Darstellung die Leiterplatte und die Tongebereinheit des Steuergeräts bei entferntem Gehäuse;
- Fig. 3: in schematischer Darstellung die Leiterplatte mit eingesteckten Kontaktelementen für die Tongebereinheit bei entfernter Tongebereinheit;
- Fig. 4: in schematischer und vergrößerter Darstellung das Steuergerät mit Leiterplatte und Tongebereinheit in Vergrößerung; und
- Fig. 5: in schematischer und vergrößerter Darstellung die Kontaktelemente.

Eine Fahrerassistenzeinrichtung gemäß einer Ausführungsform ist beispielsweise eine Einparkhilfe eines Personenkraftwagens und umfasst zwei Steuergeräte, die mit in den Stossstangen des Wagens integrierten Sensoren gekoppelt sind.

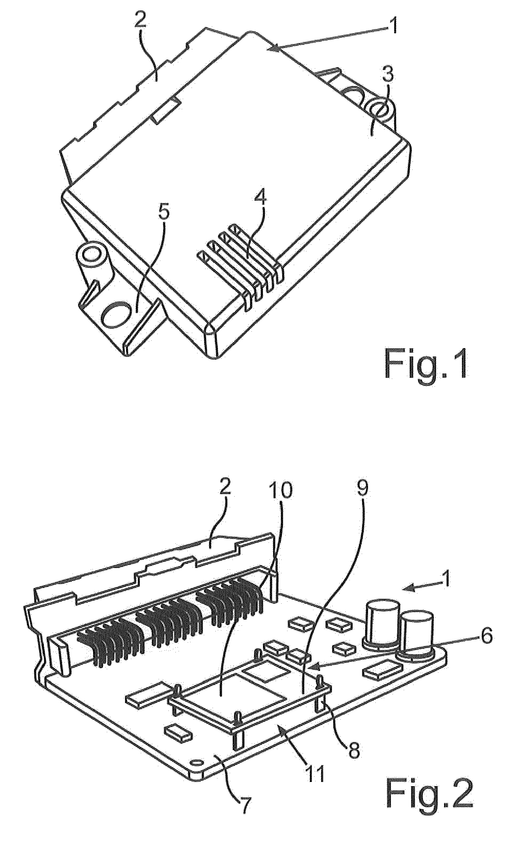

In Fig. 1 ist ein Steuergerät 1 einer Fahrerassistenzeinrichtung gemäß einer bevorzugten Ausführungsform gezeigt. Über einen Stecker 2 ist das Steuergerät 1 im eingebauten Zustand mit den Sensoren sowie der Stromversorgung gekoppelt. Ein Gehäuse 3 des Steuergerätes 1 verfügt über Ösen 5 als Einrichtungen zur Befestigung im Kraftfahrzeug und eine Öffnung 4 für die von einer Tongebereinheit 6 (s. Fig. 2) im Innern des Gehäuses 3 erzeugten akustischen Signale.

Das Gehäuse 3 erleichtert den Einbau und schützt die Tongebereinheit 6 sowie eine Leiterplatte 7 vor Schmutz und mechanischer Einwirkung. Das Steuergerät 1 wertet die Signale der über den Stecker 2 gekoppelten Sensoren aus und erzeugt mittels der integrierten Tongebereinheit 6 für den Fahrzeugführer hörbare Signale. Diese Signale repräsentieren einen von den Sensoren erfassten Zustand der Umgebung, zum Beispiel ein sich näherndes Hindernis. Das mit den Sensoren in der vorderen Stossstange verbundene Steuergerät 1 ist im vorderen Bereich des Kraftfahrzeugs befestigt, das mit den Sensoren in der hinteren Stossstange verbundene Steuergerät 1 im hinteren Bereich des Kraftfahrzeugs. Dadurch wird dem Fahrer die Assoziation der von ihm wahrgenommenen Signale mit dem von den Signalen repräsentierten vorderen oder hinteren Umgebungsbereich erleichtert. Alternativ kann nur ein Steuergerät 1 mit sowohl den vorderen als auch den hinteren Sensoren verbunden werden. Dessen Tongebereinheit erzeugt dann Signale, die Hindernisse in der vorderen als auch in der hinteren Umgebung des Kraftfahrzeugs repräsentieren.

In Fig. 2 ist das Steuergerät 1 ohne das Gehäuse 3 gezeigt, sodass Tongebereinheit 6 und Leiterplatte 7 zu sehen sind. Die Tongebereinheit 6 umfasst eine weitere Leiterplatte 9 und einen Tongeber bzw. Lautsprecher 10. Auch die Rückseite des Steckers 2 ist zu sehen. Vier Kontaktelemente 8 an den Ecken der Tongebereinheit 6, ausgeführt als Pressfit-Verbinder, koppeln die Tongebereinheit 6 und die Leiterplatte 7 elektrisch und mechanisch. Eine weitere elektrische Kopplung und/oder mechanische Verbindung ist nicht notwendig. Die Kontaktelemente 8 beabstanden die Tongebereinheit 6 und die Leiterplatte 7, sodass die Tongebereinheit 6 über der Leiterplatte 7 angebracht ist.

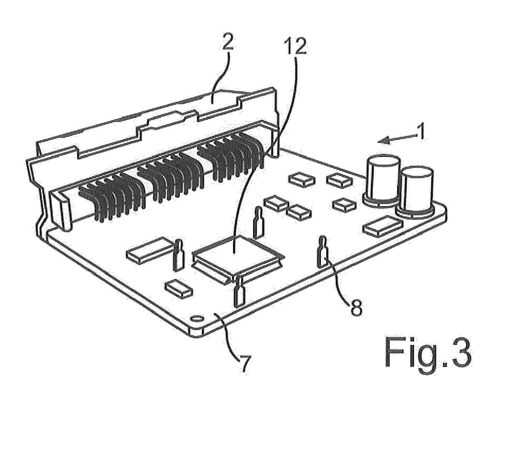

Auf der Leiterplatte 7 ist unter der Tongebereinheit 6 eine weitere elektronische Komponente 12 (s. Fig. 3) angeordnet, die in einem Zwischenraum 11 zwischen Tongebereinheit 6 und Leiterplatte 7 angeordnet ist. Fig. 2 verdeutlicht so, was unter einem "doppelstöckigen" Aufbau zu verstehen ist. Die Länge der Kontaktelemente 8 ist also so gewählt, dass unter der Tongebereinheit 6 noch Raum 11 für eine elektronische Komponente 12 (s. Fig. 3) ist; gleichzeitig aber so, dass die Tongebereinheit 6 nicht zu nah an dem (in Fig. 2 nicht gezeigten) Gehäuse 3 angeordnet ist, was den Klang beeinträchtigen würde.

Die Komponente 12 kann optional eine Steuereinheit sein, welche zur Ansteuerung der Tongebereinheit 6 über zumindest eines der Kontaktelemente 8 ausgebildet ist.

In Fig. 3 ist das Steuergerät 1 ohne die Tongebereinheit 6 gezeigt. Die vier senkrecht zur Leiterplatte 7 angeordneten Kontaktelemente 8 sind deutlich zu erkennen. Ebenfalls zu erkennen ist die unter der Tongebereinheit 6 angeordnete, zuvor von dieser verdeckte elektronische Komponente 12. Die vier Kontaktelemente 8 bilden die einzige mechanische Verbindung und gleichzeitig, da sie aus Metall geformt sind, die für Stromversorgung und Ansteuerung der Tongebereinheit 6 notwendige elektrische Kopplung.

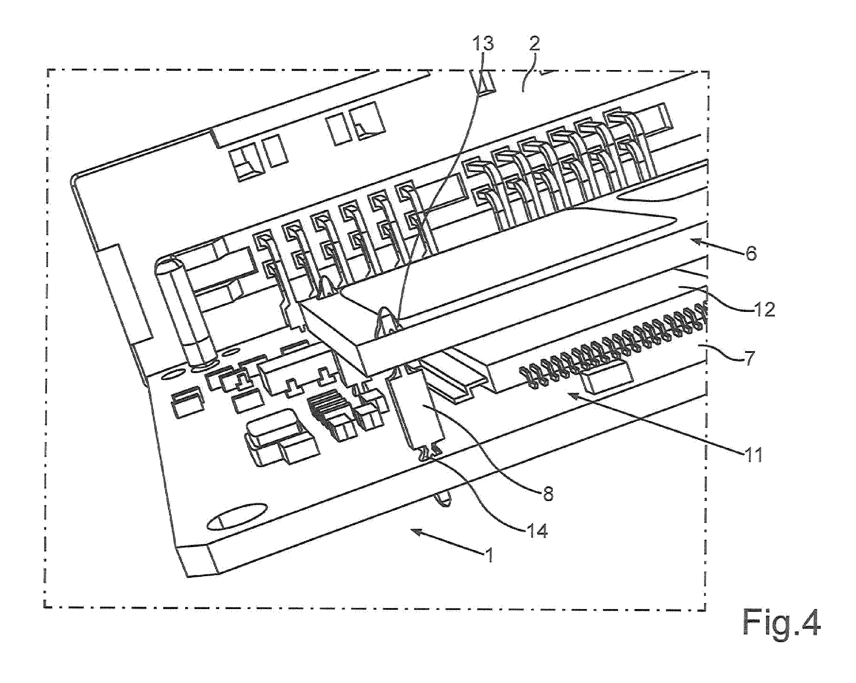

In Fig. 4 sind die Details des Aufbaus gezeigt. Zu sehen ist ein Ausschnitt des Steuergeräts 1 mit Tongebereinheit 6, Leiterplatte 7, Kontaktelementen 8 und einer unter der Tongebereinheit 6 angeordneten elektronischen Komponente 12 von der Seite. Deutlich wird so die Funktion der Kontaktelemente 8 als "Abstandshalter" zwischen Tongebereinheit 6 und Leiterplatte 7, wodurch der Raum 11 für die Komponente 12 geschaffen wird. Auf eine Darstellung der elektrischen Leiterbahnen auf Tongebereinheit 6 und Leiterplatte 7 wurde der Übersichtlichkeit halber verzichtet. Deutlich erkennbar sind Aussparungen 13 und 14 in der Tongebereinheit 6 einerseits und in der Leiterplatte 7 andererseits. In diese Aussparungen 13 und 14 sind die Kontaktelemente 8 eingepresst. Der Abstand zwischen Tongebereinheit 6 und Leiterplatte 7 - und damit, wie durch einen Vergleich mit der Oberkante des Steckers 2 erkennbar, auch zwischen Tongebereinheit 6 und Gehäuse 3 - wird durch die Länge der Kontaktelemente 8 bestimmt.

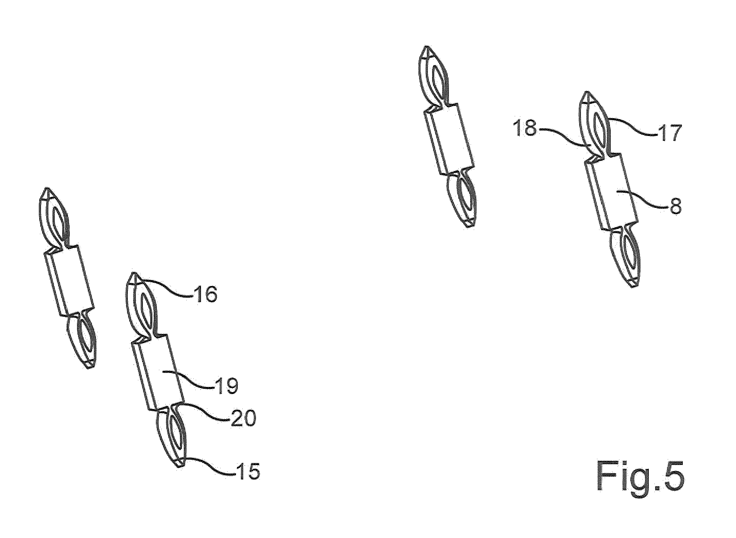

In Fig. 5 sind die Kontaktelemente 8 im Detail dargestellt. Erkennbar sind hier insbesondere plastisch bzw. elastisch verformbare Einpressbereiche 15 und 16 mit je zwei sich in einem Abstand zueinander erstreckenden Schenkeln 17 und 18. Die je gegenüberliegenden, gewölbt gekrümmten, bauchartigen äußeren Flächen der Schenkel 17, 18 erleichtern die Verformung des Einpressbereichs 15 bzw. 16 bei dem Einpressen in die Aussparungen 14 bzw. 13 von Leiterplatte 7 bzw. Tongebereinheit 6 und bilden eine form- und kraftschlüssige mechanische und elektrische Verbindung. Ein Kernbereich 19 der Kontaktelemente 8 weist ferner Anschläge 20 auf, welche den Abstand zwischen Tongebereinheit 6 und Leiterplatte 7 bestimmen und die Montage erleichtern.

Die Montage des Steuergeräts 1 erfolgt folgendermaßen: Zunächst wird die Leiterplatte 7 mit elektronischen Bauteilen sowie dem Stecker 1 bestückt. Dann werden die Kontaktelemente 8 in die Aussparungen 14 der Leiterplatte 7 eingepresst bzw. geschossen. Die Anschläge 20 erleichtern hier präzises Arbeiten. Im nächsten Schritt erfolgt das Anbringen der Tongebereinheit 6 an den Kontaktelementen 8 und somit an der Leiterplatte 7. Die Länge der Kontaktelemente 8, insbesondere der Abstand der Anschläge 20, legt hierbei den Abstand von Leiterplatte 7 und Tongebereinheit 6 fest. Schließlich wird die Einheit aus Leiteplatte 7 und Tongebereinheit 6 in dem Gehäuse 3 untergebracht.

## Patentansprüche

1. Fahrerassistenzeinrichtung für ein Kraftfahrzeug, mit einer Tongebereinheit (6) zum Ausgeben von akustischen Signalen, und mit einer Leiterplatte (7), an welche die Tongebereinheit (6) elektrisch angekoppelt ist,
**gekennzeichnet durch**
zumindest ein stiftförmiges elektrisches Kontaktelement (8), über welches die Tongebereinheit (6) an der Leiterplatte (7) gehalten und an die Leiterplatte (7) elektrisch angekoppelt ist.

2. Fahrerassistenzeinrichtung nach Anspruch 1,
**dadurch gekennzeichnet, dass**
an einem der Leiterplatte (7) zugewandten ersten Ende des Kontaktelements (8) ein plastisch und/oder elastisch verformbarer erster Einpressbereich (15) ausgebildet ist, welcher in eine korrespondierende Aussparung (14) der Leiterplatte (7) eingepresst ist und eine kraft- und formschlüssigen Verbindung mit der Leiterplatte (7) herstellt.

3. Fahrerassistenzeinrichtung nach Anspruch 1 oder 2,
**dadurch gekennzeichnet, dass**
an einem der Tongebereinheit (6) zugewandten zweiten Ende des Kontaktelements (8) ein plastisch und/oder elastisch verformbarer zweiter Einpressbereich (16) ausgebildet ist, welcher in eine korrespondierende Aussparung (13) der Tongebereinheit (6) eingepresst ist und eine kraft- und formschlüssigen Verbindung mit der Tongebereinheit (6) herstellt.

4. Fahrerassistenzeinrichtung nach einem der vorhergehenden Ansprüche,
**dadurch gekennzeichnet, dass**
die Fahrerassistenzeinrichtung eine an der Leiterplatte (7) angeordnete Steuereinheit aufweist, welche zum Ansteuern der Tongebereinheit (6) ausgebildet ist und über das zumindest eine Kontaktelement (8) mit der Tongebereinheit (6) elektrisch gekoppelt ist.

5. Fahrerassistenzeinrichtung nach einem der vorhergehenden Ansprüche,
**gekennzeichnet durch**
zumindest zwei, insbesondere vier, stiftförmige elektrische Kontaktelemente (8), über welche die Tongebereinheit (6) an der Leiterplatte (7) gehalten ist wobei eine elektrische Verbindung zwischen der Tongebereinheit (6) und die Leiterplatte (7) über zumindest eines dieser Kontaktelemente (8) bereitgestellt ist.

6. Fahrerassistenzeinrichtung nach einem der vorhergehenden Ansprüche,
**dadurch gekennzeichnet, dass**
das zumindest eine Kontaktelement (8) einen Abstand zwischen der Tongebereinheit (6) und der Leiterplatte (7) überbrückt.

7. Fahrerassistenzeinrichtung nach Anspruch 6,
**dadurch gekennzeichnet, dass**
zumindest eine elektronische Komponente (12) auf der Leiterplatte (7) angeordnet ist, welche in einem zwischen der Tongebereinheit (6) und der Leiterplatte (7) aufgrund des Abstands ausgebildeten Zwischenraum (11) angeordnet ist.

8. Fahrerassistenzeinrichtung nach Anspruch 7,
**dadurch gekennzeichnet, dass**
die Tongebereinheit (6) eine metallische Fläche aufweist, mittels welcher die elektronische Komponente (12) gegen elektromagnetische Strahlung abgeschirmt ist.

9. Fahrerassistenzeinrichtung nach einem der vorhergehenden Ansprüche,
**dadurch gekennzeichnet, dass**
die Tongebereinheit (6) einen Tongeber (10) zur Ausgabe der akustischen Signale und eine weitere Leiterplatte (9) aufweist, welche über das zumindest eine Kontaktelement (8) mit der einen Leiterplatte (7) verbunden ist.

10. Fahrerassistenzeinrichtung nach einem der vorhergehenden Ansprüche,
**dadurch gekennzeichnet, dass**
die Leiterplatte (7) und die Tongebereinheit (6) in einem gemeinsamen Gehäuse (3) angeordnet sind.

11. Fahrerassistenzeinrichtung nach einem der vorhergehenden Ansprüche,
**dadurch gekennzeichnet, dass**
die Fahrerassistenzeinrichtung ein Parkhilfesystem ist, welches zumindest einen Abstandssensor, insbesondere einen Ultraschallsensor, zum Erfassen eines Abstands zu einem Hindernis aufweist, wobei mittels der Tongebereinheit (6) akustische Signale ausgebbar sind, die den erfassten Abstand charakterisieren.

12. Kraftfahrzeug mit einer Fahrerassistenzeinrichtung nach einem der vorhergehenden Ansprüche.

13. Verfahren zum Herstellen einer Fahrerassistenzeinrichtung für ein Kraftfahrzeug, durch Bereitstellen einer Tongebereinheit (6), welche zum Ausgeben von akustischen Signalen ausgebildet ist, sowie Bereitstellen einer Leiterplatte (7), an welche die Tongebereinheit (6) elektrisch angekoppelt wird,
**dadurch gekennzeichnet, dass**
zumindest ein stiftförmiges elektrisches Kontaktelement (8) bereitgestellt wird, über welches die Tongebereinheit (6) an der Leiterplatte (7) befestigt und an die Leiterplatte (7) elektrisch angekoppelt wird.

14. Verfahren nach Anspruch 13,
**dadurch gekennzeichnet, dass**
an einem der Leiterplatte (7) zugewandten ersten Ende des Kontaktelements (8) ein plastisch und/oder elastisch verformbarer erster Einpressbereich (15) ausgebildet wird, welcher zum Herstellen einer kraft- und formschlüssigen Verbindung mit der Leiterplatte (7) in eine korrespondierende Aussparung (14) der Leiterplatte (7) eingepresst wird.

15. Verfahren nach Anspruch 13 oder 14,
**dadurch gekennzeichnet, dass**
an einem der Tongebereinheit (6) zugewandten ersten Ende des Kontaktelements (8) ein plastisch und/oder elastisch verformbarer zweiter Einpressbereich (16) ausgebildet wird, welcher zum Herstellen einer kraft- und formschlüssigen Verbindung mit der Tongebereinheit (6) in eine korrespondierende Aussparung (13) der Tongebereinheit (6) eingepresst wird.
